# EUROPEAN PATENT APPLICATION

(11) **EP 2 420 590 A1**
(43) Date of publication of application: **22.02.2012**
(21) Application number: 10764471.8
(22) Date of filing: 14.04.2010
(51) Int. Cl.: C23C 14/34, B22F 9/08, C22C 9/00

(54) **Cu-Ga ALLOY SPUTTERING TARGET AND PROCESS FOR MANUFACTURE THEREOF**

(30) Priority: 14.04.2009 JP 2009098481; 17.03.2010 JP 2010061280
(71) Applicant: Kobelco Research Institute , Inc., Kobe-shi Hyogo 651-0073 (JP)
(72) Inventor: Hiromi Matsumura, Hyogo 676-8670 (JP); Akira Nanbu, Hyogo 676-8670 (JP); Masaya Ehira, Hyogo 676-8670 (JP); Shinya Okamoto, Hyogo 676-8670 (JP)
(74) Representative: Müller-Boré & Partner Patentanwälte
(86) International application number: PCT/JP2010/056658
(87) International publication number: WO 2010/119887

(57) **Abstract**

Disclosed is a Cu-Ga alloy sputtering target which enables the formation of a Cu-Ga sputtering film having excellent uniformity in film component composition (film uniformity), enables the reduction of occurrence of arcing during sputtering, has high strength, and rarely undergoes cracking during sputtering. Specifically disclosed is a Cu-Ga alloy sputtering target which comprises a Cu-based alloy containing Ga, has an average crystal particle diameter of 10 µm or less, and has a porosity of 0.1% or less.

## Description

### TECHNICAL FIELD

The present invention relates to a Cu-Ge alloy sputtering target and a manufacturing method thereof. It relates to a Cu-Ga alloy sputtering target for use in, for example, the formation of an optical absorption layer of a CIS (CIGS) type thin film solar cell, and a manufacturing method thereof.

### BACKGROUND ART

As the formation method of the optical absorption layer of the CIS (CIGS) type thin film solar cell, a Cu-Ga alloy layer and an In layer are sequentially formed to be stacked by a sputtering method (e.g., see Patent Document 1). Further, as the sputtering target for use in the formation of the Cu-Ga alloy layer, there is generally used, for example, the one with a Ga content of 10 to 30 at%.

As the manufacturing method of the sputtering target, mention may be made of manufacturing with a melting / casting method as shown in, for example, Patent Document 2. However, manufacturing with the method results in that cooling after casting relatively slowly proceeds. Accordingly, the crystal structure increases in size, so that microscopic ununiformity of the material component occurs. Thus, the variation in composition tends to occur in the in-plane direction and the gage direction of the sputtering target. When film deposition is achieved using such a sputtering target, the resulting film also tends to undergo a variation in composition in the in-plane direction. This conceivably contributes to the reduction of the conversion efficiency of the solar cell. Further, the sputtering target manufactured with a melting / casting method tends to undergo a variation in composition in the gage direction as described above, which conceivably contributes to a variation among manufacturing lots.

Further, in the sputtering target manufactured with a melting / easting method, pores (voids) tend to be formed. When the porosity in the sputtering target is high, arcing (abnormal discharge) occurs at the pore edge portions during sputtering. Accordingly, the discharge stability of sputtering is deteriorated, and the shock of arcing generates particles, which are deposited on a substrate. This and other factors reduce the adhesion between the film and the substrate, which unfavorably results in the deterioration of the performances of the solar cell.

Further, the sputtering target manufactured by a melting / casting method has a low strength. For this reason, the target unfavorably tends to be broken due to the stress caused by the increase in temperature of the target during sputtering.

As another method for forming the sputtering target, mention may be made of a powder sintering method as shown in, for example, Patent Document 3 and Patent Document 4. With this method, an alloy powder and a pure copper powder are sintered. However, there is a limit on the refinement of the power prior to sintering, and resultingly, there is a limit on the refinement of the crystal structure. Further, there is also a limit on uniform mixing of powders.

### CITATION LIST

### PATENT DOCUMENTS

[Patent Document 1] Japanese Patent No. 3249408
[Patent Document 2] JP-A No. 2000-073163
[Patent Document 3] JP-A No. 2008-138232
[Patent Document 4] JP-A No. 2008-163367

### SUMMARY OF INVENTION

### TECHNICAL PROBLEM

The present invention was made in view of the foregoing circumstances. It is an object thereof to provide a Cu-Ga alloy sputtering target capable of forming a Cu-Ga sputtering film excellent in uniformity of the component composition of the film (film uniformity), and capable of reducing the arcing occurrence during sputtering, and having a high strength and capable of suppressing cracking during sputtering.

### SOLUTION TO PROBLEM

The present invention includes the following embodiments.
(1) A Cu-Ga alloy sputtering target including a Ga-containing Cu-based alloy, wherein the average crystal grain size is 10 µm or less, and the porosity is 0.1 % or less.
   The sputtering target is preferably a Cu-Ga alloy sputtering target substantially including a Ga-containing Cu-based alloy, and is further preferably a Cu-Ga alloy sputtering target only including a Ga-containing Cu-based alloy.
(2) The Cu-Ga alloy sputtering target according to (1), wherein the Ga content is 20 at% or more and 29 at% or less.
(3) The Cu-Ga alloy sputtering target according to (1) or (2), wherein in a scanning electron microscope observation photograph at a magnification of 500 times obtained by photographing the surface of the sputtering target, the proportion of a γ phase based on a Cu₉Ga₄ compound phase in a given line segment with a length of 100 µm is 20 % or more and 95 % or less, and the number of sections of the γ phases based on a Cu₉Ga₄ compound phase crossing the line segment is 5 or more.
(4) The Cu-Ga alloy sputtering target according to any of (1) to (3), including a Cu₉Ga₄ compound phase and a Cu₃Ga compound phase.
   The sputtering target preferably substantially includes a Cu₉Ga₄ compound phase and a Cu₃Ga compound phase, and further preferably includes only a Cu₉Ga₄ compound phase and a Cu₃Ga compound phase.
(5) A method for manufacturing the Cu-Ga alloy sputtering target according to any of (1) to (4), including:
   a first step of gas atomizing and refining a molten metal of a Ga-containing Cu-based alloy;
   a second step of depositing the refined Cu-Ga alloy on a collector, and obtaining a Cu-Ga alloy preform; and
   a third step of densifying the Cu-Ga alloy preform by a densification means, and obtaining a Cu-Ga alloy densified product.

### ADVANTAGEOUS EFFECTS OF INVENTION

In accordance with the present invention, it is possible to implement a Cu-Ga alloy sputtering target in which the crystal grains are refined, and the porosity is reduced, and which preferably has a morphology of a specific compound phase. As a result, when sputtering is performed using the target, arcing occurrence or cracking is suppressed. Accordingly, it is possible to form a Cu-Ga sputtering film having a uniform film composition with stability and efficiency, and further with a good yield as, for example, a layer forming an optical absorption layer of a CIS (CIGS) type thin film solar cell.

### BRIEF DESCRIPTION OF DRAWINGS

FIG. 1 is a view showing a Cu-Ga binary system phase diagram;
FIG. 2 is a microstructure photograph at a magnification of 500 times of a sputtering target of the present invention;
FIG. 3 is a view for illustrating a method for evaluating the morphology of the compound phase referring to FIG. 2;
FIG. 4 is a microstructure photograph at a magnification of 500 times of a sputtering target of Comparative Example;
FIG. 5 is a view for illustrating a method for evaluating the morphology of a compound phase referring to FIG. 4; and
FIG. 6 is an illustrative view for performing identification of the compound phase by an X-ray diffraction method on the sputtering target of the present invention.

### DESCRIPTION OF EMBODIMENTS

The present inventors conducted a close study on the measure in order to solve the foregoing problem. As a result, the present inventors found the following fact. By refinement of crystal grains and reduction of the porosity of a Cu-Ga alloy sputtering target, the uniformity of the material is improved. Preferably, the morphology of the compound phase is further made as specified. As a result, it is possible to improve the uniformity of the film composition of a Cu-Ga sputtering film obtained using the target. In addition, it is possible to reduce the arcing occurrence during sputtering, and it is possible to suppress cracking of the target during sputtering. Below, the sputtering target of the present invention will be described in details.

The sputtering target of the present invention is **characterized in that** the average crystal grain size is 10 µm or less, and that the porosity is 0.1 % or less. By setting the average crystal grain size at 10 µm or less, it is possible to suppress the formation of unevenness of the target surface in which erosion by sputtering has proceeded. This can stabilize the progress of erosion. As a result, it is possible to more stabilize the film thickness distribution of the formed thin film and the deposition rate of the sputtering film. The average crystal grain size is preferably 8.0 µm or less. Incidentally, from the viewpoints of the manufacturing method and the cost, the lower limit of the average crystal grain size is about 0.5 µm.

Further, the porosity is set at 0.1 % or less, so that the voids in the target are reduced. As a result, it is possible to ensure the discharge stability during sputtering, and it is possible to prevent the generation of particles due to the occurrence of arcing at the void ends. The porosity is preferably 0.05 % or less.

The Ga content of the sputtering target of the present invention is desirably 20 at% or more and 29 at% or less. When the Ga content is smaller than 20 %, the Cu phase is included, which may degrade the film uniformity. On the other hand, a Ga content of more than 29 % results in a Cu₉Ga₄ compound phase single phase, which may become more likely to be cracked. The preferred Ga content is 24 at% or more and 26 at% or less.

Further, the sputtering target of the present invention preferably has an oxygen content of 500 ppm or less. By thus reducing the oxygen content, it is possible to more reduce the arcing occurrence during sputtering. The oxygen content is preferably 400 ppm or less.

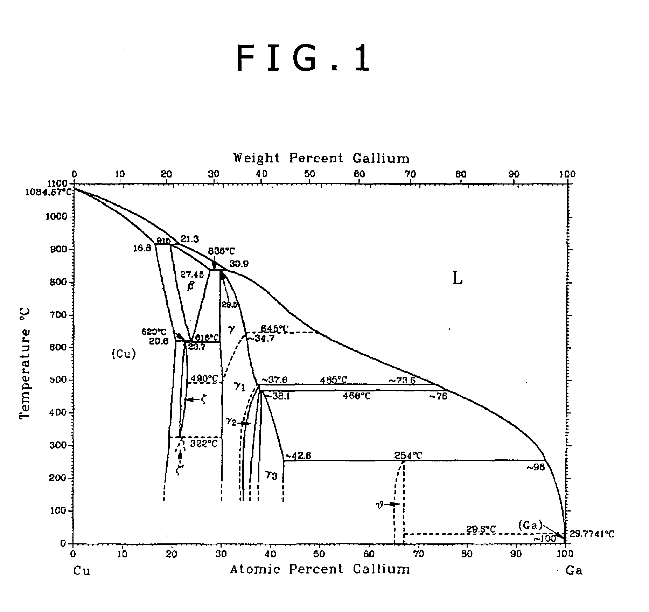

Further, the morphology of the compound phase is preferably made as follows. Namely, in the scanning electron microscope observation photograph at a magnification of 500 times obtained by photographing the surface of the sputtering target, preferably, the proportion of the intermetallic compound phase based on Cu₉Ga₄ called a γ phase shown in the Cu-Ga binary system phase diagram of FIG. 1 in a given line segment with a length of 100 µm is 20 % or more and 95 % or less, and the number of sections of the γ phases crossing the line segment is 5 or more. The more preferred proportion of the γ phase in a given line segment with a length of 100 µm is 30 % or more and 50 % or less. Further, the more preferred number of sections of the γ phases crossing the line segment is 6 or more.

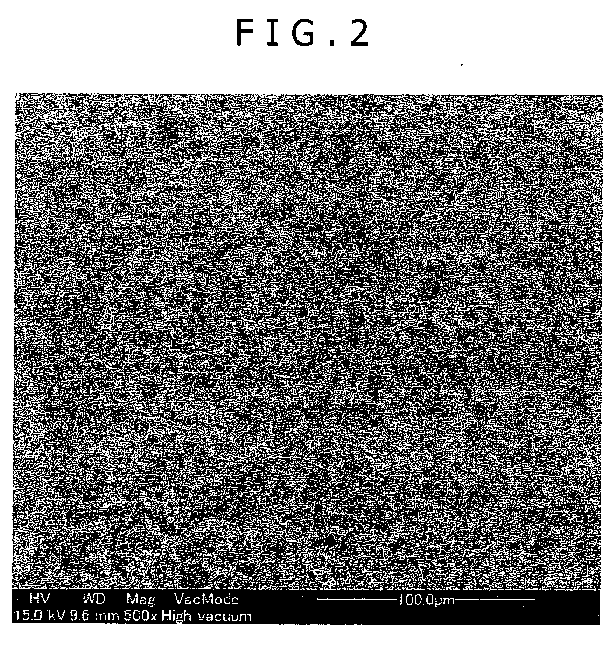

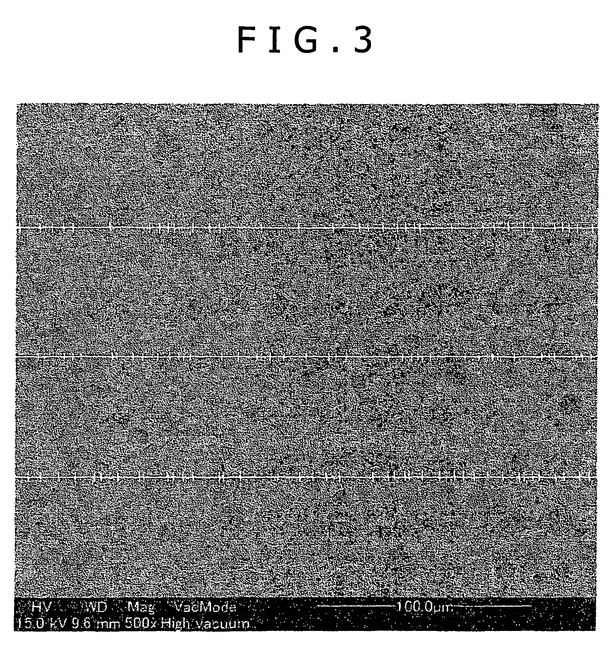

Below, a description will be given to the measurement methods of the "proportion of a γ phase based on a Cu₉Ga₄ compound phase in a given line segment with a length of 100 um" and " the number of sections of the γ phases based on the Cu₉Ga₄ compound phase crossing the line segment".
In the scanning electron microscope observation photograph (reflection electron image) at a magnification of 500 times obtained by photographing the surface of the sputtering target, the proportion of the γ phase based on a Cu₉Ga₄ compound phase in a given line segment with a length of 100 µm, and the number of sections of the γ phases based on the Cu₉Ga₄ compound phase crossing the line segment will be described by reference to FIG. 3 obtained by drawing line segments in FIG. 2 described above for, for example, Example 1. For a given line segment (about 270 µm) in FIG. 3, there are drawn lines (short vertical lines in FIG. 3) at boundaries between the light gray portions and the dark gray portions. Then, the "proportion of the γ phase based on the Cu₉Ga₄ compound phase in a given line segment with a length of 100 µm" can be determined in the following manner. The lengths of the line segments occupied by the light gray portions are summed up. The proportion of the sum in the total length of the line segments is determined, and is converted into a value per 100 µm. Whereas, the "number of sections of the γ phases based on the Cu₉Ga₄ compound phase crossing a given line segment with a length of 100 µm" can be determined in the following manner. The number of sections occupied by the light gray portions out of the sections separated by the vertical lines is determined, and is converted into a value per 100 µm. Alternatively, as shown in FIG. 3, the proportions / numbers of the phases of given three line segments may be determined as described above, respectively, to calculate the average value thereof. Incidentally, the direction of each line segment does not particularly matter.

As the compound phase forming the Cu-Ga alloy sputtering target, mention may be made of, for example, a ξ phase based on Cu₃Ga or a γ phase based on Cu₉Ga₄. However, when the proportion of the γ phase out of these falls within the range of 20 % or more and 95 % or less, the target cracking during the sputtering can be sufficiently suppressed. When the γ phase is present in a proportion of more than 95 %, the compound phase becomes nearly the γ single phase. Accordingly, the target may become more likely to be cracked during sputtering. On the other hand, a proportion of less than 20 % results in the occurrence of the Cu phase. Accordingly, the film uniformity may be degraded.

For the scanning electron microscope observation photograph, the measurements are performed with the methods illustrated in Examples described later with an observation photograph with a visual field size of 270 µm × 230 µm and at a magnification of 500 times as the object. At this step, the following preferably satisfied: the average value of the proportions of the γ phases is 20 % or more, and the average value of the numbers of the γ phases is 5 or more. Incidentally, in Examples described later, the measurements are performed on three line segments in the same direction in the observation photograph. However, the direction of each line segment does not particularly matter.

### (Manufacturing method of Cu-Ga alloy sputtering target)

The present invention also specifies a manufacturing method of the sputtering target. The method is characterized by including:
a first step of gas atomizing and refining a molten metal of a Ga-containing Cu-based alloy (Cu-Ga alloy);
a second step of depositing the refined Cu-Ga alloy on a collector, and obtaining a Cu-Ga alloy preform; and
a third step of densifying the Cu-Ga alloy preform by a densification means, and obtaining a Cu-Ga alloy densified product. Particularly, when the method (method including a spray forming method in which the molten metal of the Ga-containing Cu-based alloy is deposited on the collector while being gas atomized) is adopted, it is possible to make uniform the component composition and the structure of the sputtering target. In addition, it is possible to implement the morphology of the compound phase. Thus, the adoption of the method is preferable.

Below, preferred conditions and the like in respective steps will be described in details.

First, in the first step, the following gas atomization is performed. The Ga-containing Cu-based alloy (Cu-Ga alloy, raw material) is heated to the melting point thereof or higher temperatures, resulting in a molten metal. The molten metal is flowed down from a nozzle, and a gas is sprayed from the surroundings to the molten metal for atomization.

Thus, gas atomization is performed to deposit the particles quenched from the semi-molten state to the semi-solidified state, and further to the solid phase state, resulting in a pre-machining formed material in a prescribed shape (preform, intermediate product before obtaining a final densified product) (second step). With the spray forming method, a large-size preform difficult to obtain by a melting casting method or a powder sintering method can be obtained in a single step.

In the first step, a molten metal of a Cu-Ga alloy obtained from melting within the range of roughly 1000 to 1300 °C is gas-atomized to be refined. In the gas atomization, the molten metal is flowed from the nozzle. From the surroundings thereof, for example, an inert gas (e.g., Ar) or a nitrogen gas is sprayed to the molten metal for atomization. The gas / metal ratio expressed as the ratio of gas flow rate / molten metal flow rate can be set at, for example, 2.0 to 8.0 Nm³/kg.

When the average particle diameter (the average value of equivalent-sphere diameters of the resulting all fine particles) of the particles (fine particles) atomized by the gas atomization is 200 µm or less, the fine particles tend to be quenched. Accordingly, the crystal structure in each fine particle becomes further finer, so that the average crystal grain size of the target can be made smaller. Therefore, such a case is preferable.

While performing gas atomization, the Cu-Ga alloy atomized by the gas atomization is deposited on a collector, resulting in a Cu-Ga alloy preform (second step).

Mention may be made of control of the spray distance (the distance between the tip of the nozzle and the center of the collector) within the range of, for example, 500 to 1000 mm during the deposition.

Then, the resulting Cu-Ga alloy preform is densified by a densification means (third step). Examples of the densification means may include densification by sealing and hot isostatic pressing (HIP). As the conditions for the HIP, for example, mention may be made of a treatment under a pressure of 80 MPa or more and at a temperature of 400 to 600 °C for roughly 1 to 10 hours.

Then, the Cu-Ga alloy densified product is machined. As a result, it is possible to obtain the sputtering target of the present invention.

### [Examples]

Below, the present invention will be described more specifically by way of examples. However, the present invention is by no means limited by the following examples, and can naturally be put into practice by adding appropriate changes within the scope applicable to the gists described above and later. All of these are included in the technical scope of the present invention

### (Examples 1 and 2)

A molten metal of a Cu-Ga alloy containing Ga in an amount of 25 at%, and including the balance of Cu and inevitable impurities was obtained from heating to 1200 °C in an induction melting furnace. Then, the molten metal was flowed from a nozzle set at the lower part of the induction melting furnace. A nitrogen gas was sprayed to the flowed molten metal, resulting in fine droplets. The droplets were uniformly piled up on a collector at a tilt angle of 35°, rotating at a distance (spray distance) of 500 to 1000 mm from the nozzle in a gas metal ratio of 2.0 to 8.0 Nm³/kg. As a result, a Cu-Ga alloy preform (density: about 75 vol%) was manufactured. The Cu-Ga alloy preform manufactured by the spray forming method was sealed and subjected to hot isostatic pressing (HIP) under a temperature of 500 °C to 600 °C and under a pressure of 80 MPa or more, resulting in a Cu-Ga densified product.

Then, the resulting densified product was machined to manufacture a Cu-Ga alloy sputtering target (size: 250 mm in length × 250 mm in width × 10 mm in thickness), which was referred to as Example 1.

Further, in Example 2, a Cu-Ga alloy sputtering target was manufactured in the same manner as in Example 1, except that HIP was performed under a temperature of 400 °C to 500 °C.

Further, in Example 3, a Cu-Ga alloy sputtering target was manufactured by a spray forming method in the same manner as in Example 1, except for using a molten metal of a Cu-Ga alloy containing Ga in an amount of 20 at%, and including the balance of Cu and inevitable impurities.

Further, in Example 4, a Cu-Ga alloy sputtering target was manufactured by a spray forming method in the same manner as in Example 1, except for using a molten metal of a Cu-Ga alloy containing Ga in an amount of 29 at%, and including the balance of Cu and inevitable impurities.

The analyzed oxygen contents of the resulting Cu-Ga alloy sputtering targets of Examples 1 to 4 were measured by an inert gas melting method, and were found to be 250 to 310 ppm. Further, the structure of the Cu-Ga alloy sputtering target manufactured in Example 1 was observed under a scanning electron microscope (SEM). The observation photograph (reflection electron image) is shown in FIG. 2. In FIG. 2, each light gray portion indicates a γ phase based on a Cu₉Ga₄ compound phase; each dark gray portion indicates a ξ phase based on a Cu₃Ga compound phase; and each black portion indicates a pore (void).

Further, identifications of the average crystal grain size, the porosity, and the compound phase of each Cu-Ga alloy sputtering target of Examples 1 to 4, and evaluation of the morphology of the compound phase (the proportion of the γ phase based on the Cu₉Ga₄ compound phase in a given line segment with a length of 100 µm in a scanning electron microscope observation photograph obtained by photographing the surface of the sputtering target at a magnification 500 times) were performed in the following manner.

### (Measurement of average crystal grain size)

Using a specimen cut from the Cu-Ga alloy sputtering target, surface polishing was performed. Then, using an etchant (ferric chloride + hydrochloric acid + water), the surface was etched to prepare a sample. Then, the sample was observed / photographed by a SEM. Using a microstructure photograph at a magnification of 500 times (visual field size: 270 µm × 230 µm, 1 visual field), with the cutting method according to the Methods for Estimating Average Grain Size of Wrought Copper and Copper-Alloys of JISH 0501, the number of crystal grains and the cut lengths were measured. The average value thus calculated was referred to as the average crystal grain size.

### (Measurement of porosity)

The area ratio (%) of pores (the black portions in FIG. 2, for example, for Example 1) in the microstructure photograph (visual field size: 270 µm × 230 µm) at a magnification of 500 times was referred to as the porosity (%).

### (Identification of compound phase)

Using an X-ray diffraction device (RINT 1500 manufactured by RIGAKU), identification was performed.

The measurement conditions of the X-ray diffraction were as described below.
Scanning speed: 2°/min
Sampling width: 0.02°
Target output: 40 kV, 200 mA
Measurement range (2θ): 20° to 100°

### (Morphology of compound phase)

There were determined the proportion of the γ phases based on the Cu₉Ga₄ compound phase in a given line segment with a length of 100 µm, and the number of sections of the γ phases based on the Cu₉Ga₄ compound phase crossing the line segment in the scanning electron microscope observation photograph (reflection electron image) at a magnification of 500 times obtained by photographing the surface of the sputtering target. As an example thereof, the case of Example 1 will be described referring to FIG. 3 obtained by drawing line segments in FIG. 2. For a given line segment (about 270 µm) in FIG. 3, there were drawn lines (short vertical lines in FIG. 3) at boundaries between the light gray portions and the dark gray portions. Then, the "proportion of the γ phase based on the Cu₉Ga₄ compound phase in a given line segment with a length of 100 µm" was determined in the following manner. The lengths of the line segments occupied by the light gray portions were summed up. The proportion of the sum in the total length of the line segments was determined, and was converted into a value per 100 µm. Whereas, the "number of sections of the γ phases based on the Cu₉Ga₄ compound phase crossing a given line segment with a length of 100 µm" was determined in the following manner. The number of sections occupied by the light gray portions out of the sections separated by the vertical lines was determined, and was converted into a value per 100 µm. Then, as shown in FIG. 3, the proportions / numbers of the phases of given three line segments may be determined as described above, respectively, to calculate the average value thereof.

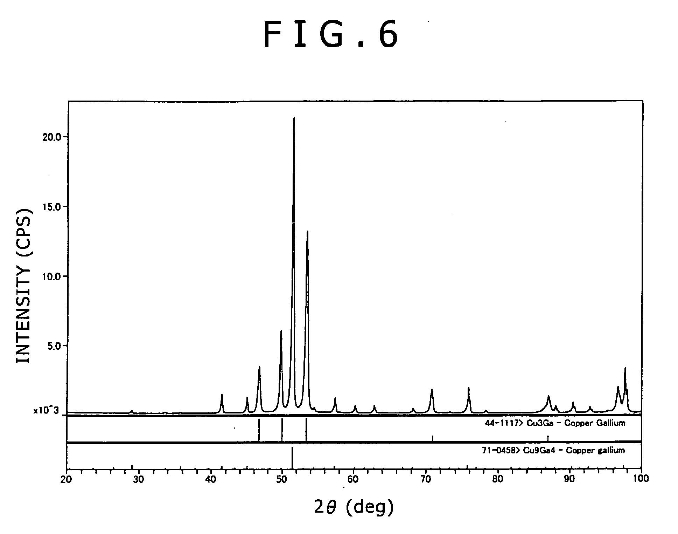

Incidentally, it has been confirmed with an X-ray diffraction method that the main body of the light gray portion (phase with a contrast closer to white) in FIG. 3 is an intermetallic compound based on a Cu₉Ga₄ compound phase referred to as a γ phase (FIG. 6).

These results are shown in Table 1. Using the resulting sputtering targets, the following evaluations were performed.

### (Evaluation of film uniformity)

Using the Cu-Ga alloy sputtering targets, with a DC magnetron sputtering method, a Cu-Ga sputtering film was formed on each glass substrate (size: 100 mm × 100 mm × 0.50 mm).

The conditions for the sputtering were as shown below.
Substrate temperature: room temperature
Ultimate vacuum: 3 × 10⁻⁵ Torr or less (1 × 10⁻³ Pa or less)
Gas pressure during deposition: 1 to 4 mTorr
DC sputtering power density (DC sputtering power per unit area of target): 1.0 to 20 W/cm²

Using samples including the Cu-Ga sputtering films formed therein, the sheet resistances at given 9 sites in the same film plane on each glass substrate were measured. Then, the evaluation was performed as follows: the case where all the values at the 9 sites fall within a 9-site average value of ±3 % or less is referred to as A (the film uniformity is favorable); and the case where the value at one or more sites out of the nine sites exceeds the 9-site average value of ±3 % is referred to as C (the film uniformity is poor). The results are shown in Table 1.

### (Evaluation of arcing)

Further, during DC magnetron sputtering in the evaluation of the film uniformity, the number of occurrences of arcing was counted by an arc monitor connected to an electric circuit of a sputtering device. Counting of the number of occurrences of arcing was performed during 10-minute sputtering after 10-minute pre-sputtering. Then, the case where the number of arcing is 10 or more is rated as C (sputtering poor condition). The case where the number of occurrences of arcing is 9 or less is rated as A (sputtering good condition). The results are shown in Table 1.

### (Evaluation of cracking occurrence)

Using each of the Cu-Ga alloy sputtering targets, DC magnetron sputtering was repeatedly performed. Thus, the case where the target remaining thickness at the sputtering target surface erosion deepest part is 1mm is referred to as "life end". The case where complete cracking occurs until the life end is rated as C; the case where the degree of cracking is minute, as B; and the case where no cracking occurs until the life end, as A. The results are shown in Table 1.

Incidentally, in the overall rating in Table 1, the samples rated as A on any of the film uniformity, the arcing occurrence, and cracking occurrence are rated as A. The samples rated as C on one or more of the film uniformity, arcing occurrence, and cracking occurrence are rated as C. Other samples are rated as B.

### (Comparative Example 1)

In Comparative Example 1, a Cu-Ga alloy sputtering target was manufactured by a spray forming method in the same manner as in Example 1, except that the gas metal ratio was set at 1.0 Nm³/kg. Then, there were performed identifications of the average crystal grain size, the porosity, and the compound phase of the Cu-Ga alloy sputtering target, and measurement of the morphology of the compound phase, and evaluation of the film uniformity, evaluation of arcing occurrence, and evaluation of cracking occurrence in the same manner as in the examples. The results are shown together in Table 1.

### (Comparative Example 2)

In Comparative Example 2, a Cu-Ga alloy sputtering target was manufactured by a spray forming method in the same manner as in Example 1, except that the HIP pressure was set at 40 MPa. Then, there were performed identifications of the average crystal grain size, the porosity, and the compound phase of the Cu-Ga alloy sputtering target, and measurement of the morphology of the compound phase, and evaluation of the film uniformity, evaluation of arcing occurrence, and evaluation of cracking occurrence in the same manner as in the examples. The results are shown together in Table 1.

### (Comparative Example 3)

A molten metal of a Cu-Ga alloy containing Ga in an amount of 25 at%, and including the balance of Cu and inevitable impurities was casted into a mold, thereby manufacturing an ingot. The resulting ingot was machined to manufacture a Cu-Ga alloy sputtering target (melting method).

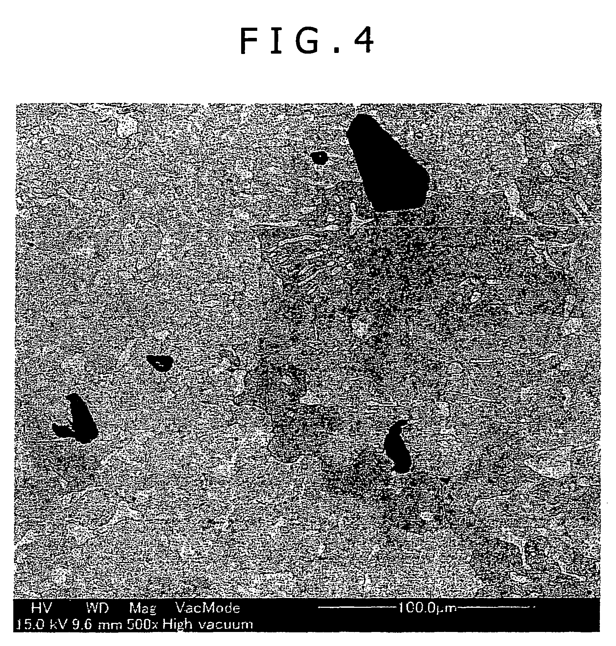

The structure of the Cu-Ga alloy sputtering target was observed under a scanning electron microscope (SEM). The observation photograph (reflection electron image) is shown in FIG. 4. In FIG. 4, as in FIG. 2, each light gray portion indicates a γ phase based on a Cu₉Ga₄ compound phase; each dark gray portion indicates a ξ phase based on a Cu₃Ga compound phase; and each black portion indicates a pore (void).

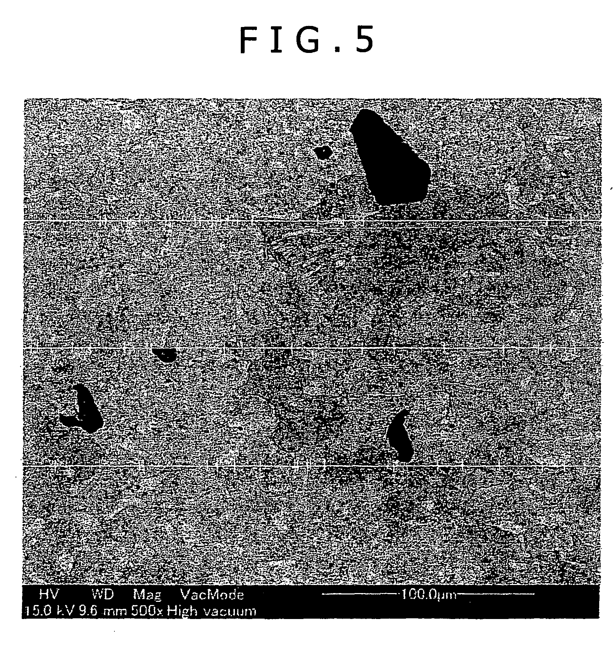

Further, there were performed identifications of the average crystal grain size, the porosity, and the compound phase of the Cu-Ga alloy sputtering target, and measurement of the morphology of the compound phase, and evaluation of the film uniformity, evaluation of arcing occurrence, and evaluation of cracking occurrence in the same manner as in the examples. The results are shown together in Table 1. Incidentally, the morphology of the compound phase was rated referring to FIG. 5 in the same manner as in Example 1.

### (Comparative Example 4)

A molten metal of a Cu-Ga alloy containing Ga in an amount of 25 at%, and including the balance of Cu and inevitable impurities was casted into a mold, thereby manufacturing an ingot. The resulting ingot was pulverized and sintered to manufacture a Cu-Ga alloy sputtering target (powder sintering method).

Then, there were performed identifications of the average crystal grain size, the porosity, and the compound phase of the Cu-Ga alloy sputtering target, and measurement of the morphology of the compound phase, and evaluation of the film uniformity, evaluation of arcing occurrence, and evaluation of cracking occurrence in the same manner as in the examples. The results are shown together in Table 1.

### (Comparative Example 5)

In Comparative Example 5, a Cu-Ga alloy sputtering target was manufactured by a spray forming method in the same manner as in Example 1, except for using a molten metal of a Cu-Ga alloy containing Ga in an amount of 15 at%, and including the balance of Cu and inevitable impurities. Then, there were performed identifications of the average crystal grain size, the porosity, and the compound phase of the Cu-Ga alloy sputtering target, and measurement of the morphology of the compound phase, and evaluation of the film uniformity, evaluation of arcing occurrence, and evaluation of cracking occurrence in the same manner as in the examples. The results are shown together in Table 1.

### (Comparative Example 6)

In Comparative Example 6, a Cu-Ga alloy sputtering target was manufactured by a spray forming method in the same manner as in Example 1, except for using a molten metal of a Cu-Ga alloy containing Ga in an amount of 35 at%, and including the balance of Cu and inevitable impurities. Then, there were performed identifications of the average crystal grain size, the porosity, and the compound phase of the Cu-Ga alloy sputtering target, and measurement of the morphology of the compound phase, and evaluation of the film uniformity, evaluation of arcing occurrence, and evaluation of cracking occurrence in the same manner as in the examples. The results are shown together in Table 1.

**[Table 1]**

| | Manufacturing method | Composition | Average crystal grain size (µm) | Porosity (%) | Identification results of phase by X-ray diffraction | Morphology of γ phase | | Film uniformity | Arcing occurrence | Cracking occurrence | Overall rating |
|---|---|---|---|---|---|---|---|---|---|---|---|
| | | | | | | Proportion (%) *1 | Number (phase sections) *2 | | | | |
| Example 1 | Spray forming method | Cu-25at%Ga | 7.0 | 0.007 | Cu₉Ga₄, Cu₃Ga | 46.5 | 6.9 | A | A | A | A |
| Example2 | Spray forming method | Cu-25at%Ga | 9.1 | 0.005 | Cu₉Ga₄, Cu₃Ga | 34.9 | 5.5 | A | A | B | B |
| Comparative example 1 | Spray forming method | Cu-25at%Ga | 13.6 | 0.008 | Cu₉Ga₄, Cu₃Ga | 23.3 | 14 | C | A | A | C |
| Comparative example 2 | Spray forming method | Cu-25at%Ga | 7.0 | 0.8 | Cu₉Ga₄, Cᵤ₃Ga | 46.4 | 7.2 | A | C | A | C |
| Comparative example 3 | Melting method | Cu-25at%Ga | 12.4 | 0.38 | Cu₉Ga₄, Cu₃Ga | 13.5 | 2.9 | C | C | C | C |
| Comparative example 4 | Powder sintering method | Cu-25at%Ga | 16 | 0.14 | Cu₉Ga₄,Cu₃Ga | 31.2 | 6.5 | C | C | A | C |
| Example 3 | Spray forming method | Cu-20at%Ga | 9.9 | 0.006 | C₉Ga₄, Cu₃Ga | 37.6 | 5.3 | A | A | A | A |
| Example 4 | Spray forming method | Cu-29at/°Ga | 9.4 | 0.009 | CuGa₄, CuGa | 90.2 | 5.0 | A | A | B | B |
| Comparative example 5 | Spray forming method | Cu-15at%Ga | 15.0 | 0.005 | Cu, Cu₃Ga | 0 | 0 | C | A | A | C |
| Comparative example 6 | Spray forming method | Cu-35at%Ga | 9.2 | 0.007 | CU₉Ga₄ | 100 | - | A | A | C | C |

| | | | | | | | | | | | |
|---|---|---|---|---|---|---|---|---|---|---|---|
| *1 Proportion of a γ phase based on a CuGa₄ compound phase in a line segment per 100 µm in length *2 Number of sections of the γ phases based on a Cu₉Ga₄ compound phase crossing a line segment per 100 µm in length | | | | | | | | | | | |

The results shown in Table 1 indicate the following: in each Cu-Ga alloy sputtering target of the present invention satisfying the specified requirements, as compared with the sputtering targets manufactured with conventional methods (the melting method of Comparative Example 3, the powder sintering method of Comparative Example 4), the crystal grains are fine and uniform, and pores are small in number. Further, the following is also indicated: when sputtering is performed by using such targets, the frequency of occurrence of arcing during sputtering is low, and cracking does not occur until the life end, also resulting in a high yield of targets used. Still further, it is also indicated that the film uniformity of the resulting sputtering film is good.

Whereas, it is indicated as follows: in the spray forming method specified according to the present inventive method, desirably, the conditions such as the gas metal ratio, the HIP pressure, and the HIP temperature are controlled to satisfy the specified requirements such as the average crystal grain size and the porosity.

For Comparative Example 1, the average crystal grain size did not satisfy the requirement of the present invention, so that the film uniformity was poor. For Comparative Example 2, the porosity did not satisfy the requirement of the present invention. Thus, the arcing occurrence frequency was high, resulting in poor sputtering. For Comparative Example 5, the Ga content and the average crystal grain size did not satisfy the requirements of the present invention, resulting in poor film uniformity. For Comparative Example 6, the Ga content and the proportion of the γ phase did not satisfy the requirements of the present invention. Thus, cracking occurred until the life end, leading to a poor result.

The present application was described in details and by reference to specified embodiments. However, it is obvious to those skilled in the art that various changes and modifications may be added without departing from the spirit and scope of the present invention.
The present application is based on Japanese Patent Application No. 2009-098481 filed on April 14, 2009, and Japanese Patent Application No. 2010-061280 filed on March 17, 2010, the contents of which are incorporated herein by reference.

### INDUSTRIAL APPLICABILITY

In accordance with the present invention, it is possible to implement a Cu-Ga alloy sputtering target in which the crystal grains are refined, and the porosity is reduced, and which preferably has a morphology of a specific compound phase. As a result, when sputtering is performed using the target, arcing occurrence or cracking is suppressed. Accordingly, it is possible to form a Cu-Ga sputtering film having a uniform film composition with stability and efficiency, and further with a good yield as, for example, a layer forming an optical absorption layer of a CIS (CIGS) type thin film solar cell.

## Claims

1. A Cu-Ga alloy sputtering target comprising a Ga-containing Cu-based alloy, wherein the average crystal grain size is 10 µm or less, and the porosity is 0.1 % or less.

2. The Cu-Ga alloy sputtering target according to claim 1, wherein the Ga content is 20 at% or more and 29 at% or less.

3. The Cu-Ga alloy sputtering target according to claim 1, wherein in a scanning electron microscope observation photograph at a magnification of 500 times obtained by photographing the surface of the sputtering target, the proportion of a γ phase based on a Cu₉Ga₄ compound phase in a given line segment with a length of 100 µm is 20 % or more and 95 % or less, and the number of sections of the γ phases based on a Cu₉Ga₄ compound phase crossing the line segment is 5 or more.

4. The Cu-Ga alloy sputtering target according to claim 1, comprising a Cu₉Ga₄ compound phase and a Cu₃Ga compound phase.

5. A method for manufacturing the Cu-Ga alloy sputtering target according to any of claims 1 to 4, comprising:
a first step of gas atomizing and refining a molten metal of a Ga-containing Cu-based alloy;
a second step of depositing the refined Cu-Ga alloy on a collector, and obtaining a Cu-Ga alloy preform; and
a third step of densifying the Cu-Ga alloy preform by a densification means, and obtaining a Cu-Ga alloy densified product.
